# EUROPÄISCHE PATENTANMELDUNG

(11) **EP 0 984 290 A1**
(43) Veröffentlichungstag der Anmeldung: **08.03.2000**
(21) Anmeldenummer: 99117218.0
(22) Anmeldetag: 01.09.1999
(51) Int. Cl.: G01R 31/28, H01L 21/66

(54) **Verfahren zum Betrieb einer integrierten Schaltung**

(30) Priorität: 01.09.1998 DE 19839807
(71) Anmelder: SIEMENS AKTIENGESELLSCHAFT, 80333 München (DE)
(72) Erfinder: Schneider, Helmut, 80993 München (DE)

(57) **Zusammenfassung**

Vor einer Vereinzelung der integrierten Schaltung (IC) wird das Schaltelement (SW1) leitend geschaltet und es werden Signale zwischen der internen Signalleitung (L1) und der externen Signalleitung (L2), die sich in einem Sägebereich (5) des Wafers (W) befindet, übertragen. Die integrierte Schaltung wird vereinzelt, wobei die Verbindung zwischen dem Schaltelement (SW1) und der externen Signalleitung (L2) an einer Trennstelle (2) unterbrochen wird. Nach der Vereinzelung wird das Schaltelement (SW1) dauerhaft gesperrt, um die interne Signalleitung (L1) von der Trennstelle (2) abzukoppeln.

## Beschreibung

Die Erfindung betrifft ein Verfahren zum Betrieb einer integrierten Schaltung.

Um die Funktion integrierter Schaltungen zu Testen, ist es üblich, auf ihnen zusätzliche Kontaktierungsstellen vorzusehen, die im Normalbetrieb der Schaltung nicht benötigt werden und die in einer Testbetriebsart der Zuführung von Testsignalen beziehungsweise der Ausgabe von zu überwachenden Signalen dienen. Allerdings ist es ein ständiges Ziel, die Fläche einer integrierten Schaltung möglichst klein zu halten. Daher ist es erforderlich, die Anzahl der Kontaktierungsstellen möglichst gering zu halten. Aus der US 5,047,711 A ist es bekannt, einen Wafer, auf dem sich integrierte Schaltungen vor ihrer Vereinzelung befinden, mit Kontaktierungsstellen zu versehen, die sich wenigstens teilweise in Sägebereichen (Scribe Lanes) des Wafers befinden. Diese Kontaktierungsstellen sind mit den integrierten Schaltungen verbunden und erlauben einen Test der Schaltungen, solange sie noch nicht vereinzelt sind. Die Vereinzelung der integrierten Schaltungen erfolgt durch Zerteilung des Wafers entlang seiner Sägebereiche.

Der Erfindung liegt die Aufgabe zugrunde, ein Verfahren zum Betrieb einer integrierten Schaltung anzugeben, der vor ihrer Vereinzelung ebenfalls Signale über den Wafer zuführbar sind, wobei eine verbesserte Funktionsfähigkeit der Schaltung gewährleistet ist.

Diese Aufgabe wird mit einem Verfahren gemäß Patentanspruch 1 gelöst. Vorteilhafte Aus- und Weiterbildungen der Erfindung sind Gegenstand abhängiger Ansprüche.

Das erfindungsgemäße Betriebsverfahren für eine integrierte Schaltung mit einer internen Signalleitung und einem Schichtelement, wobei die integrierte Schaltung vor einer Vereinzelung auf einem Wafer angeordnet ist, auf dem ihre interne Signalleitung über das Schaltelement mit einer außerhalb in einem Sägebereich des Wafers verlaufenden externen Signalleitung verbunden ist, sieht folgende Schritte vor:

Vor der Vereinzelung der integrierten Schaltung wird das Schaltelement leitend geschaltet, und es werden über das Schaltelement Signale zwischen der internen Signalleitung und der externen Signalleitung übertragen. Die integrierte Schaltung wird vereinzelt, wobei die Verbindung zwischen dem Schaltelement und der externen Signalleitung an einer Trennstelle unterbrochen wird. Nach der Vereinzelung wird das Schaltelement dauerhaft gesperrt, um die interne Signalleitung von der Trennstelle abzukoppeln.

Die Erfindung beruht auf der Erkenntnis, daß bei der erwähnten US 5,047,711 A nach der Vereinzelung der integrierten Schaltungen deren zuvor mit den in den Sägebereichen des Wafers befindlichen Kontaktierungsstellen aufgrund des mechanischen Trennprozesses während der Vereinzelung unter Umständen ungewollt mit Bereichen der integrierten Schaltung verbunden werden, über die ihnen Signale zugeführt werden, die einen negativen Einfluß auf das Betriebsverhalten der Schaltung nehmen.

Die Erfindung sieht also vor, negative Beeinflussungen der integrierten Schaltung nach ihrer Vereinzelung, die beispielsweise durch im Verlaufe der Vereinzelung auftretende Kurzschlüsse der Trennstelle oder durch das Floaten der Trennstelle nach erfolgter Vereinzelung bedingt sind, dadurch auszuschließen, daß die Trennstelle nach Vereinzelung mittels des Schaltelementes von der internen Signalleitung und damit vom Rest der Schaltung abgekoppelt wird.

Nach einer Weiterbildung der Erfindung wird nach der Vereinzelung der integrierten Schaltung der der Trennstelle zugewandte Anschluß des Schaltelementes mit einem festem Potential verbunden. Dies verhindert ein Floaten des Potentials an der Trennstelle.

Wenn die integrierte Schaltung vor oder nach ihrer Vereinzelung mit einer elektrisch leitfähigen Schutzumhüllung versehen wird, die anschließend mit einem festen Potential verbunden wird, so ist es vorteilhaft, die Trennstelle ebenfalls mit diesem festen Potential zu verbinden. Der Grund hierfür ist, daß der der Trennstelle zugewandte Anschluß des Schaltelementes nach der Vereinzelung oftmals Kontakt mit der leitfähigen Schutzumhüllung hat. Es ist dann günstig, wenn dieser Anschluß und die Schutzumhüllung mit demselben festen Potential verbunden werden.

Der Schaltzustand des Schaltelementes kann auf unterschiedlichste Weise beeinflußt werden. Eine Möglichkeit ist die Steuerung des Schaltzustandes über wenigstens ein extern der integrierten Schaltung zugeführtes Signal. Dies kann entweder direkt oder indirekt, durch Auslösung einer Testbetriebsart der integrierten Schaltung über das extern zugeführte Signal, erfolgen, wobei in der Testbetriebsart das Schaltelement leitend geschaltet wird. Eine weitere Möglichkeit zur Steuerung des Schaltzustandes des Schaltelementes kann durch Programmierung wenigstens eines programmierbaren Elementes der integrierten Schaltung erfolgen. Der Schaltzustand ist dann abhängig vom Programmierzustand des programmierbaren Elementes. Das programmierbare Element kann beispielsweise eine Laserfuse sein, die im unzerstörten Zustand dafür sorgt, daß das Schaltelement leitend ist. Vor der Vereinzelung der integrierten Schaltung kann die Laserfuse dann mittels eines Laserstrahls aufgetrennt werden, wodurch das Schaltelement dauerhaft gesperrt wird.

Eine weitere Möglichkeit, den Schaltzustand des Schaltelementes zu beeinflussen, sieht vor, daß das Schaltelement einen Steuereingang aufweist, der vor der Vereinzelung der integrierten Schaltung mit einer Steuerleitung verbunden ist, die wenigstens teilweise im Sägebereich des Wafers verläuft, entlang dessen dieser bei der Vereinzelung zerteilt wird. Dabei wird dem Steuereingang vor der Vereinzelung über die Steuerleitung ein Steuerpotential zugeführt, als Folge dessen das Schaltelement leitend geschaltet wird. Während der Vereinzelung wird die Steuerleitung aufgetrennt, so daß dem Steuereingang das Steuerpotential nicht mehr zugeführt wird und das Schaltelement dadurch dauerhaft gesperrt wird.

In diesem Fall handelt es sich bei der Steuerleitung um ein programmierbares Element, dessen Programmierung automatisch durch die Vereinzelung der integrierten Schaltung erfolgt.

Die Erfindung wird im folgenden anhand der Figuren näher erläutert.

Es zeigen:
- Figur 1: einen Wafer mit mehreren integrierten Schaltungen, die sich zur Durchführung des erfindungsgemäßen Verfahrens eignen und
- Figuren 2 bis 5: verschiedene Möglichkeiten, ein Schaltelement der integrierten Schaltung zu deaktivieren.

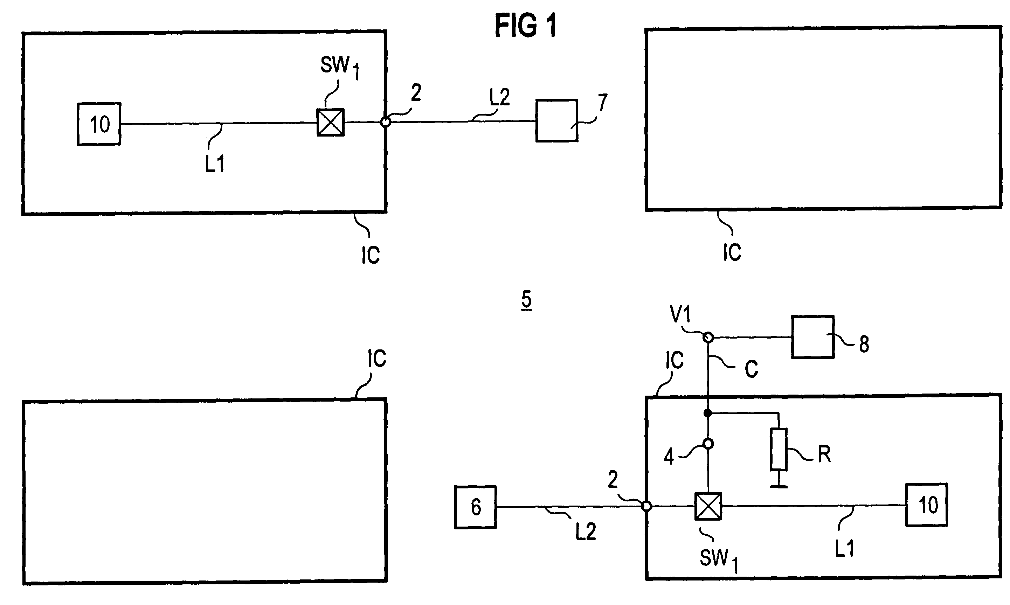

Figur 1 zeigt ausschnittsweise einen Wafer W auf dem sich integrierte Schaltungen IC befinden, von denen in Figur 1 lediglich vier dargestellt sind. Die integrierten Schaltungen IC weisen Schaltungseinheiten 10 auf, die über eine interne Signalleitung L1 und ein erstes Schaltelement SW1 mit einer externen Signalleitung L2 verbunden sind. Die integrierten Schaltungen IC sind voneinander durch Sägebereiche 5 des Wafers getrennt. Für eine Vereinzelung der integrierten Schaltungen erfolgt ein Zerteilen des Wafers W entlang seiner Sägebereiche 5. Die Figur 1 ist nicht maßstäblich. In der Realität sind die Sägebereiche 5 sehr viel schmaler als die integrierten Schaltungen IC.

In einer Testbetriebsart der integrierten Schaltungen IC sind ihre ersten Schaltelemente SW1 leitend geschaltet, so daß zwischen den Schaltungseinheiten 10 und den entsprechenden externen Signalleitungen L2 Signale übertragen werden können. Im Falle der integrierten Schaltung IC links oben in Figur 1 ist die externe Signalleitung L2 mit einer Kontaktierungsstelle 7 im Sägebereich 5 des Wafers W verbunden. Im Falle der integrierten Schaltung rechts unten in Figur 1 ist die externe Signalleitung L2 mit einer Testeinrichtung 6 verbunden, die sich ebenfalls im Sägebereich 5 befindet. Die Kontaktierungsstelle 7 kann im Testbetrieb mit Prüfspitzen kontaktiert werden, so daß über diese Signale von und oder zur Schaltungseinheit 10 übertragbar sind. Im zweiten Fall generiert die Testeinrichtung 6 Testsignale, die sie über das erste Schaltelement SW1 zur Schaltungseinheit 10 überträgt.

Während die ersten Schaltelemente SW1 in der Testbetriebsart leitend geschaltet sind, so daß über die Kontaktierungsstelle 7 beziehungsweise die Testeinrichtung 6 ein Test der Schaltungseinheiten 10 erfolgen kann, werden die ersten Schaltelemente SW1 außerhalb der Testbetriebsart gesperrt. Auf diese Weise kann nach der Vereinzelung der integrierten Schaltungen IC die Verbindung der internen Signalleitung L1 zu einer Trennstelle 2 unterbrochen werden, an der die externe Signalleitung L2 beim Zerteilen des Wafers W während der Vereinzelung der integrierten Schaltung IC von letzteren getrennt wird.

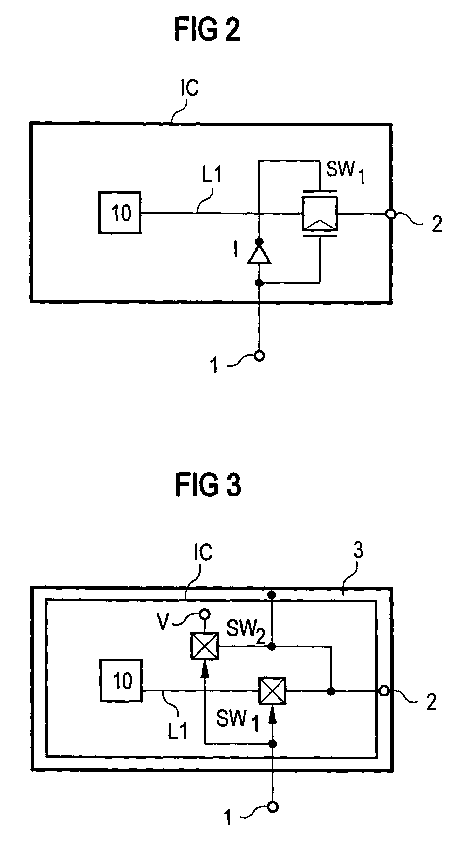

Figur 2 zeigt eine erste Möglichkeit, den Schaltzustand des ersten Schaltelementes SW1 einer der integrierten Schaltungen IC zu beeinflussen. In diesem Fall ist das erste Schaltelement SW1 ein Transfergate, daß einen n-Kanal-Transistor und einen p-Kanal--Transistor aufweist. Ein Eingang 1 der integrierten Schaltung IC ist mit dem Gate des p-Kanal-Transistors und über einen Inverter I mit dem Gate des n-Kanal-Transistors verbunden. Der Schaltzustand des ersten Schaltelementes SW1 wird in diesem Fall über den Eingang 1 direkt durch Anlegen eines externen Steuersignals beeinflußt. Figur 2 zeigt die integrierte Schaltung IC nach ihrer Vereinzelung, bei der der Wafer W aus Figur 1 entlang seiner Sägebereiche 5 zerteilt worden ist. Während dieser Vereinzelung wird die Verbindung zwischen dem ersten Schaltelement SW1 und der im Sägebereich 5 des Wafers W verlaufenden externen Signalleitung an der Trennstelle 2 unterbrochen. Über den Eingang 1 in Figur 2 erfolgt anschließend ein dauerhaftes Sperren des erstes Schaltelementes SW1, um die interne Signalleitung L1 von der Trennstelle 2 abzukoppeln.

Die vereinzelte integrierte Schaltung IC aus Figur 3 weist ein zweites Schaltelement SW2 auf, daß ein festes Potential V mit der Trennstelle 2 und einer elektrisch leitfähigen Schutzumhüllung 3 der integrierten Schaltung IC verbindet, mit der diese nach Ihrer Vereinzelung versehen worden ist. Der Eingang 1 der integrierten Schaltung IC, über den der Schaltzustand des ersten Schaltelementes SW1 beeinflußt wird, ist in Figur 3 auch mit einem Steuereingang des zweiten Schaltelementes SW2 verbunden. Wenn das erste Schaltelement SW1 leitend ist, ist das zweite Schaltelement SW2 gesperrt und umgekehrt. Bei der Schaltung IC in Figur 3 wird also gleichzeitig mit dem Sperren des ersten Schaltelementes SW1 die Trennstelle 2 und die Schutzumhüllung 3 mit dem festen Potential V verbunden, so daß beide ein definiertes Potential aufweisen.

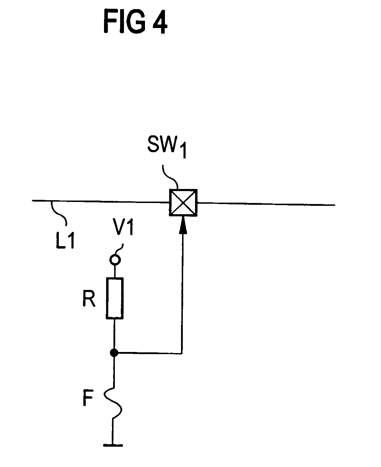

Figur 4 ist eine andere Möglichkeit zu entnehmen, den Schaltzustand des ersten Schaltelementes SW1 zu beeinflussen. In diesem Fall erfolgt des Steuern des ersten Schaltelementes SW1 nicht über ein extern zugeführtes Steuersignal wie in Figur 2 und 3, sondern mittels eines programmierbaren Elementes F in Form einer Laserfuse. In der Testbetriebsart ist das programmierbare Element F zunächst nicht aufgetrennt, so daß der Steuereingang des Schaltelementes SW1 über dieses mit Masse verbunden ist, so daß es leitend geschaltet ist. Vor der Vereinzelung der integrierten Schaltung erfolgt ein Auftrennen des programmierbaren Elementes F, so daß am Steuereingang des ersten Schaltelementes SW1 ein festes Potential V1 anliegt, das mit dem Steuereingang über ein Widerstandselement R verbunden ist. Daraufhin sperrt das erste Schaltelement SW1.

Figur 1 ist eine weitere Möglichkeit zu entnehmen, den Schaltzustand des ersten Schaltelementes SW1 zu beeinflussen. Bei der integrierten Schaltung IC rechts unten in Figur 1 ist ein Steuereingang 4 des ersten Schaltelementes SW1 vor der Vereinzelung über eine Steuerleitung C mit einem festen Potential V1 verbunden, daß dem Sägebereich 5 zugeführt wird. Außerdem ist der Steuereingang 4 über ein Widerstandselement R auf der integrierten Schaltung IC mit Masse verbunden. Vor der Vereinzelung sorgt das feste Potential V1 dafür, daß das erste Schaltelement SW1 leitet. Nach der Vereinzelung, während der die Steuerleitung C unterbrochen wird, da sie im Sägebereich des Wafers W verläuft, liegt über das Widerstandselement R, das als Pull-Down-Widerstand wirkt, Masse am Steuereingang 4 an, woraufhin das erste Schaltelement SW1 sperrt. In diesem Fall folgt eine Programmierung des Schaltzustandes des ersten Schaltelementes SW1 automatisch durch das Vereinzeln der integrierten Schaltung IC, während der die Steuerleitung C unterbrochen wird.

## Patentansprüche

1. Verfahren zum Betrieb einer integrierten Schaltung (IC),
- wobei die integrierte Schaltung eine interne Signalleitung (L1) und ein Schaltelement (SW1) aufweist,
- wobei die integrierte Schaltung (IC) vor einer Vereinzelung auf einem Wafer (W) angeordnet ist, auf dem ihre interne Signalleitung (L1) über das Schaltelement (SW1) mit einer in einem Sägebereich (5), entlang dessen der Wafer (W) bei der Vereinzelung zerteilt wird, verlaufenden externen Signalleitung (L2) verbunden ist,
mit folgenden Schritten:
- vor der Vereinzelung der integrierten Schaltung (IC) wird das Schaltelement (SW1) leitend geschaltet und es werden über das Schaltelement Signale zwischen der internen Signalleitung (L1) und der externen Signalleitung (L2) übertragen,
- die integrierte Schaltung (IC) wird vereinzelt, wobei die Verbindung zwischen dem Schaltelement (SW1) und der externen Signalleitung (L2) an einer Trennstelle (2) unterbrochen wird,
- nach der Vereinzelung wird das Schaltelement (SW1) dauerhaft gesperrt, um die interne Signalleitung (L1) von der Trennstelle (2) abzukoppeln.

2. Verfahren nach Anspruch 1,
bei dem nach der Vereinzelung der integrierten Schaltung (IC) der der Trennstelle (2) zugewandte Anschluß des Schaltelementes (SW1) mit einem festen Potential (V) verbunden wird.

3. Verfahren nach Anspruch 2,
bei dem die integrierte Schaltung (IC) mit einer elektrisch leitfähigen Schutzumhüllung (3) versehen wird, die ebenfalls mit dem festen Potential (V) verbunden wird.

4. Verfahren nach einem der vorstehenden Ansprüche,
bei dem der Schaltzustand des Schaltelementes (SW1) über wenigstens ein der integrierten Schaltung (IC) von extern zugeführtes Signal (1) gesteuert wird.

5. Verfahren nach einem der Ansprüche 1 bis 3,
bei dem der Schaltzustand des Schaltelementes (SW1) durch Programmierung wenigstens eines programmierbaren Elementes (F; C) der integrierten Schaltung (IC) beeinflußt wird.

6. Verfahren nach Anspruch 5,
- wobei das Schaltelement (SW1) einen Steuereingang (4) aufweist, der vor der Vereinzelung der integrierten Schaltung (IC) mit einer Steuerleitung (C) verbunden ist, die wenigstens teilweise im Sägebereich (5) des Wafers (W) verläuft,
- bei dem dem Steuereingang (4) vor der Vereinzelung über die Steuerleitung (C) ein Steuerpotential (V1) zugeführt wird, als Folge dessen das Schaltelement leitend geschaltet wird,
- und bei dem während der Vereinzelung die Steuerleitung (C) aufgetrennt wird, so daß das Steuerpotential (V1) dem Steuereingang (4) nicht mehr zugeführt wird und das Schaltelement (SW1) dadurch dauerhaft gesperrt wird.
